# EUROPEAN PATENT APPLICATION

(11) **EP 2 940 783 A1**
(43) Date of publication of application: **04.11.2015**
(21) Application number: 15165392.0
(22) Date of filing: 28.04.2015
(51) Int. Cl.: H01P 1/201, H01P 11/00

(54) **TEM MODE DIELECTRIC FILTER AND MANUFACTURING METHOD THEREOF**

(30) Priority: 30.04.2014 CN 201410181445
(71) Applicant: Huawei Technologies Co., Ltd., Longgang District Shenzhen, Guangdong 518129 (CN)
(72) Inventor: Zhou, Yanzhao, 518129, P.R. Shenzhen (CN); Gu, Jian, 518129, P.R. Shenzhen (CN); Wan, Wei, 518129, P.R. Shenzhen (CN)
(74) Representative: Lord, Michael

(57) **Abstract**

Embodiments of the present invention provide a TEM mode dielectric filter and a manufacturing method thereof. The mode dielectric filter provided by the present invention includes a dielectric body (1) and a silver plating layer (2), where the silver plating layer covers a surface of the dielectric body, and a dielectric constant of the dielectric body is less than or equal to 21. The TEM dielectric filter provided by the present invention has a large energy storage space in a single resonant cavity of a dielectric material, and has a high quality factor. An insertion loss of the TEM dielectric filter is low, and electrical conductivity of the silver plating layer is high.

## Description

### TECHNICAL FIELD

Embodiments of the present invention relate to the communications field, and in particular, to a TEM mode dielectric filter and a manufacturing method thereof.

### BACKGROUND

With fast development of communications technologies, sizes of communications system devices are becoming smaller, and therefore, requirements on communications components such as filters are increasingly high. A communications component needs to have not only good reliable performance and a low insertion loss, but also a small enough volume and high frequency selectivity.

A transverse electromagnetic (Transverse Electromagnetic, TEM for short) mode dielectric filter is a common radio frequency component, and is applied in a wireless microphone, a terminal, a printed circuit board (Printed Circuit Board, PCB for short) of a network device, and so on. The TEM mode dielectric filter in the prior art includes a ceramic dielectric body and a silver plating layer that is formed on a surface of the ceramic body by a conductive sintered silver paste, where the ceramic dielectric body is used as a dielectric resonant cavity, and the silver plating layer forms a metal cavity. In the prior art, an energy storage space of the ceramic dielectric body of the TEM mode dielectric filter is small, resulting in a high insertion loss of the filter.

### SUMMARY

Embodiments of the present invention provide a TEM dielectric filter and a manufacturing method thereof, to improve electrical conductivity of a dielectric body of the TEM mode dielectric filter, thereby reducing an insertion loss of the TEM mode dielectric filter.

According to a first aspect, an embodiment of the present invention provides a TEM mode dielectric filter, where the TEM mode dielectric filter includes a dielectric body and a silver plating layer, where the silver plating layer covers a surface of the dielectric body, and a dielectric constant of the dielectric body is less than or equal to 21.

With reference to the first aspect, in a first possible implementation manner of the first aspect, the silver plating layer is a sputtering silver plating layer; or
the silver plating layer is a chemical catalytic silver plating layer; or
the silver plating layer includes a sputtering silver plating layer and a chemical catalytic silver plating layer that are formed in sequence on the surface of the dielectric body, where the sputtering silver plating layer is located between the dielectric body and the chemical catalytic silver plating layer; or
the silver plating layer includes a chemical catalytic copper plating layer and a chemical catalytic silver plating layer that are formed in sequence on the surface of the dielectric body, where the chemical catalytic copper plating layer is located between the dielectric body and the chemical catalytic silver plating layer.

With reference to any one possible implementation manner of the first aspect and the first possible implementation manner of the first aspect, in a second possible implementation manner of the first aspect, the dielectric constant of the dielectric body is between 7 and 21.

With reference to the first aspect or either of the first and second possible implementation manners of the first aspect, in a third possible implementation manner of the first aspect, the dielectric body includes an aluminum oxide based ceramic material, a quadrivalent silicate based ceramic material, a quinquevalent vanadate based ceramic material, or a hexavalent tungstate/molybdate based ceramic material.

With reference to the first aspect or any one of the first, second, and third possible implementation manners of the first aspect, in a fourth possible implementation manner of the first aspect, a thickness of the silver plating layer is 3-15 micrometers.

According to a second aspect, an embodiment of the present invention provides a method for manufacturing a TEM mode dielectric filter, where the method includes the following process:
acquiring a dielectric body, where a dielectric constant of the dielectric body is less than or equal to 21;
performing corrosion processing on a surface of the dielectric body; and
performing plating processing on the surface of the dielectric body after the corrosion processing to form a silver plating layer.

With reference to the second aspect, in a first possible implementation manner of the second aspect, the performing plating processing on the surface of the dielectric body after the corrosion processing to form a silver plating layer includes:
performing sputtering silver plating processing on the surface of the dielectric body after the corrosion processing to form a sputtering silver plating layer; or
performing chemical catalytic silver plating processing on the surface of the dielectric body after the corrosion processing to form a chemical catalytic silver plating layer; or
performing sputtering silver plating processing on the surface of the dielectric body after the corrosion processing to form a sputtering silver plating layer, and performing chemical catalytic silver plating processing on a surface of the sputtering silver plating layer to form a chemical catalytic silver plating layer; or
performing chemical catalytic copper plating processing on the surface of the dielectric body after the corrosion processing to form a chemical catalytic copper plating layer, and performing chemical catalytic silver plating processing on a surface of the chemical catalytic copper plating layer to form a chemical catalytic silver plating layer.

With reference to either of the second aspect and the first possible implementation manner of the second aspect, in a second possible implementation manner of the second aspect, in a case in which the plating processing is sputtering silver plating processing, an adopted control bias voltage is 0.1-10Pa, and an adopted power is 1-40W/cm².

With reference to either of the first and second possible implementation manners of the second aspect, in a third possible implementation manner of the second aspect, in a case in which plating processing is chemical catalytic silver plating processing, an adopted silver plating solution includes the following components: 0.01-650g/L silver salt, 1-1000mL/L ammonium bifluoride, 0.01-210g/L ammonium carbonate and/or ammonium bicarbonate, and 0.01-210g/L hydrazine hydrate, and a speed for performing the chemical catalytic silver plating processing is 0.1-2um/h.

With reference to the third possible implementation manner of the second aspect, in a fourth possible implementation manner of the second aspect, the silver salt is silver nitrate.

With reference to the second aspect or any one of the first to fifth possible implementation manners of the second aspect, in a sixth possible implementation manner of the second aspect, a thickness of the silver plating layer is 3-15 micrometers.

With reference to the second aspect or any one of the first to sixth possible implementation manners of the second aspect, in a seventh possible implementation manner of the second aspect, the dielectric constant of the dielectric body is greater than or equal to 7 and less than or equal to 21.

With reference to the seventh possible implementation manner of the second aspect, in an eighth possible implementation manner of the second aspect, the dielectric body includes an aluminum oxide based ceramic material, a quadrivalent silicate based ceramic material, a quinquevalent vanadate based ceramic material, or a hexavalent tungstate/molybdate based ceramic material.

As can be known, according to the TEM dielectric filter and manufacturing method thereof provided by the present invention, a dielectric body of mode dielectric filter is changed, a material having a dielectric constant that is less than or equal to 21 is used as the dielectric body, and a silver plating layer is formed on a surface of the dielectric body, so that an energy storage space of a single resonant cavity of the dielectric body is increased. Therefore, electrical conductivity of the dielectric body of the TEM mode dielectric filter is improved effectively, and an insertion loss of the TEM mode dielectric filter is reduced.

### BRIEF DESCRIPTION OF DRAWINGS

To describe the technical solutions in the embodiments of the present invention or in the prior art more clearly, the following briefly introduces the accompanying drawings required for describing the embodiments or the prior art. Apparently, the accompanying drawings in the following description show some embodiments of the present invention, and a person of ordinary skill in the art may still derive other drawings from these accompanying drawings without creative efforts.
FIG. 1 is a schematic structural diagram of an embodiment of a TEM mode dielectric filter according to the present invention;
FIG. 2 is a schematic diagram of an appearance of a dielectric single resonant cavity having a dielectric constant of 21;
FIG. 3 is a schematic diagram of an appearance of a dielectric single resonant cavity having a dielectric constant of 9;
FIG. 4 is a schematic structural diagram of another embodiment of a TEM mode dielectric filter according to the present invention;
FIG. 5 is a schematic structural diagram of still another embodiment of a TEM mode dielectric filter according to the present invention;
FIG. 6 is a flowchart of Embodiment 1 of a method for manufacturing a TEM mode dielectric filter according to the present invention;
FIG. 7 is an electron micrograph of a surface of a dielectric body magnified by 5000 times after corrosion processing; and
FIG. 8 is an electron micrograph of a surface of a dielectric body magnified by 5000 times without processing.

### DESCRIPTION OF EMBODIMENTS

To make the objectives, technical solutions, and advantages of embodiments of the present invention clearer, the following clearly and completely describes the technical solutions in the embodiments of the present invention with reference to the accompanying drawings in the embodiments of the present invention. Apparently, the described embodiments are some but not all of the embodiments of the present invention. All other embodiments obtained by a person of ordinary skill in the art based on the embodiments of the present invention without creative efforts shall fall within the protection scope of the present invention.

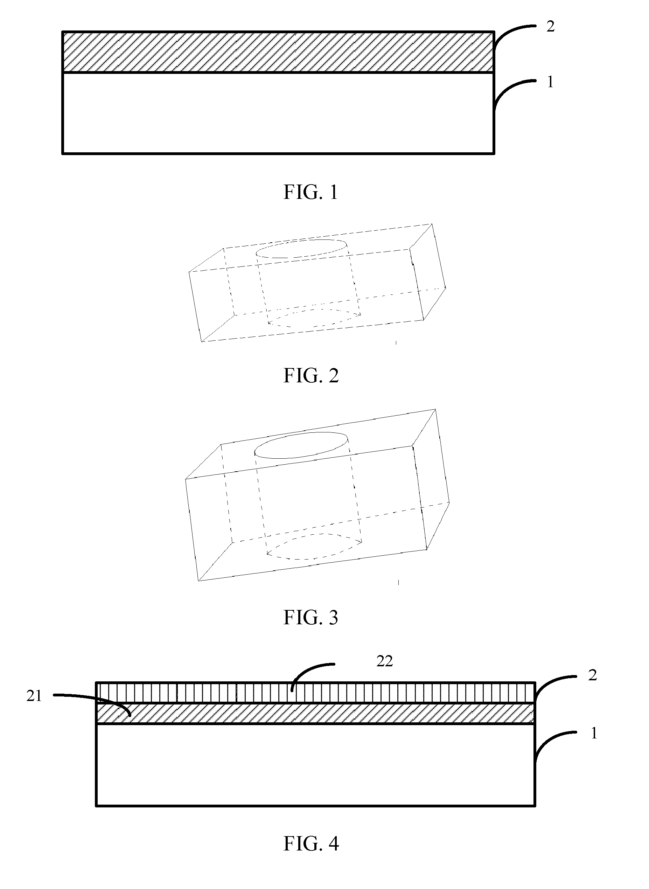

TEM mode dielectric filters provided by the embodiments are applied in scenarios of a small cell base station in a next-generation radio access network, a large-scale input/output system, a lightweight base station, and so on. FIG. 1 is a schematic structural diagram of an embodiment of a TEM mode dielectric filter according to the present invention. The TEM mode dielectric filter includes a dielectric body 1 and a silver plating layer 2, where the silver plating layer 2 covers a surface of the dielectric body 1, and a dielectric constant of the dielectric body 1 is less than or equal to 21.

According to the TEM dielectric filter provided by this embodiment, the dielectric body of the TEM mode dielectric filter is changed, a material having a dielectric constant that is less than or equal to 21 is used as the dielectric body, and a silver plating layer is formed on the surface of the dielectric body. Therefore, electrical conductivity of the dielectric body is improved effectively, and an insertion loss of the TEM mode dielectric filter is reduced.

On a basis of the foregoing embodiment, generally a material having a dielectric constant between 7 and 21 is used as the dielectric body 1. For example, for a material having a dielectric constant of 7.5, in a 1.8G resonant cavity test, a Q value reaches 1800 . According to a microwave theory, a wavelength of an electromagnetic wave is in inverse proportion to a square root of a dielectric constant K of a material. In a case in which a length and a width of a resonant cavity are unchanged, a cavity of a material having a low dielectric constant has a greater depth. Therefore, a material having a low dielectric constant is used to increase a Q value of the TEM mode dielectric filter.

For example, FIG. 2 is a schematic diagram of an appearance of a dielectric single resonant cavity having a dielectric constant of 21; and FIG. 3 is a schematic diagram of an appearance of a dielectric single resonant cavity having a dielectric constant of 9. As shown in FIG. 2 and FIG. 3, by using a low-K material Er9, under a condition that a length and a width of a single resonant cavity are unchanged, a cavity depth is 52.7% greater than that of a material having a K value of 21. After an energy storage space is increased, the Q value of the filter may be increased by about 20%.

Materials that can be used as the dielectric body 1 of the TEM mode dielectric filter may be mainly classified into the following types: an aluminum oxide based ceramic material, a quadrivalent silicate based ceramic material, a quinquevalent vanadate based ceramic material, or a hexavalent tungstate/molybdate based ceramic material, and so on. Molding processing needs to be performed on these dielectric bodies in advance. Generally, a sintering temperature of the TEM mode dielectric body is above 1100 degrees Celsius.

Further, on a basis of the foregoing embodiment, the silver plating layer may have the following forms:

A first form is a sputtering silver plating layer; sputtering silver plating is performed on the surface of the dielectric body, and a silver plating layer with a thickness of 3-15 micrometers is formed.

A second form is a chemical catalytic silver plating layer; chemical catalytic silver plating is performed on the surface of the dielectric body, and a silver plating layer with a thickness of 3-15 micrometers is formed.

A third form is a sputtering silver plating layer and a chemical catalytic silver plating layer that covers the sputtering silver plating layer. FIG. 4 is a schematic structural diagram of another embodiment of the TEM mode dielectric filter according to the present invention. As shown in FIG. 4, the silver plating layer 2 includes a sputtering silver plating layer 21 and a chemical catalytic silver plating layer 22 that are formed in sequence on the surface of the dielectric body, where the sputtering silver plating layer 21 is located between the dielectric body 1 and the chemical catalytic silver plating layer 22. A total thickness of the sputtering silver plating layer 21 and the chemical catalytic silver plating layer 22 is 3-15 micrometers.

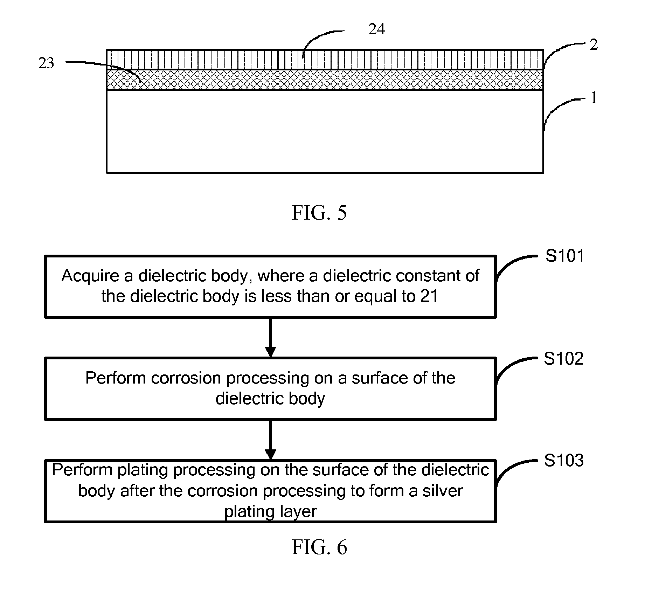

A fourth form is a chemical catalytic copper plating layer and a chemical catalytic silver plating layer. FIG. 5 is a schematic structural diagram of still another embodiment of the TEM mode dielectric filter according to the present invention. As shown in FIG. 5, the silver plating layer 2 includes a chemical catalytic copper plating layer 23 and a chemical catalytic silver plating layer 24 that are formed in sequence on the surface of the dielectric body 1, where the chemical catalytic copper plating layer 23 is located between the dielectric body 1 and the chemical catalytic silver plating layer 24. A total thickness of the chemical catalytic copper plating layer 23 and the chemical catalytic silver plating layer 24 is 3-15 micrometers.

According to the TEM dielectric filter provided by this embodiment, the dielectric body of the mode dielectric filter is changed, and a material having a dielectric constant that is less than or equal to 21 is used as the dielectric body to increase the energy storage space of a single resonant cavity of the dielectric body and increase a quality factor of the filter. In addition, a silver plating layer is formed on the surface of the dielectric body, and an improvement is made on the silver plating layer to form a denser silver layer on the surface. Therefore, electrical conductivity is improved effectively, and an insertion loss of the filter is reduced.

FIG. 6 is a flowchart of Embodiment 1 of a method for manufacturing a TEM mode dielectric filter according to the present invention. As shown in FIG. 6, the manufacturing method includes:

S101. Acquire a dielectric body, where a dielectric constant of the dielectric body is less than or equal to 21.

In this embodiment, a selected dielectric material having a dielectric constant that is less than or equal to 21 undergoes molding processing in advance to form a dielectric body of a required shape, for subsequent processing.

S102. Perform corrosion processing on a surface of the dielectric body.

In this embodiment, ceramic surface activation is performed on the dielectric body by using a corrosion technology. Specifically, a chemical solution may be used to perform surface corrosion and energy activation on the ceramic dielectric body for 15-30 seconds.

S103. Perform plating processing on the surface of the dielectric body after the corrosion processing to form a silver plating layer.

In this embodiment, a specific manner of performing plating processing on the surface of the dielectric body to form a silver plating layer is: attaching a film sticker on the surface of the dielectric body after the corrosion preprocessing, masking areas except a silver plating layer area, performing plating processing on the surface of the dielectric body to which the film sticker is attached to form the silver plating layer, and after the plating is completed, removing the masking material, that is, the film sticker.

According to the method for manufacturing the TEM mode dielectric filter provided by this embodiment, a dielectric body having a dielectric constant that is less than or equal to 21 is acquired, and the dielectric body is preprocessed, and further, plating processing is performed to form a silver plating layer. Therefore, an energy storage space of a single resonant cavity of the material of the dielectric body is increased, and a quality factor of the filter is increased.

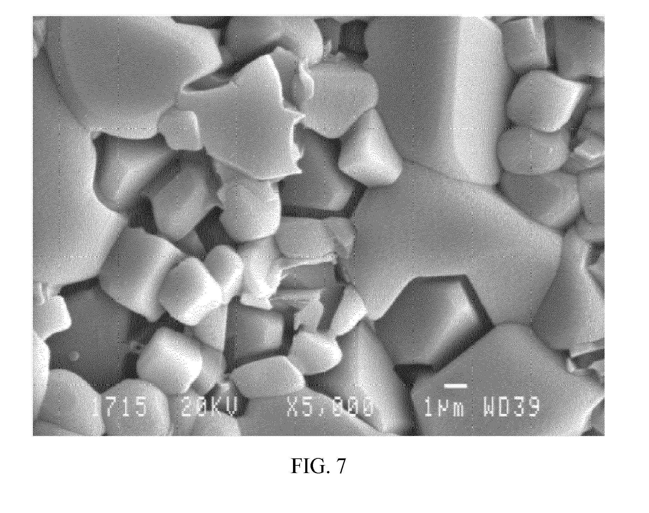

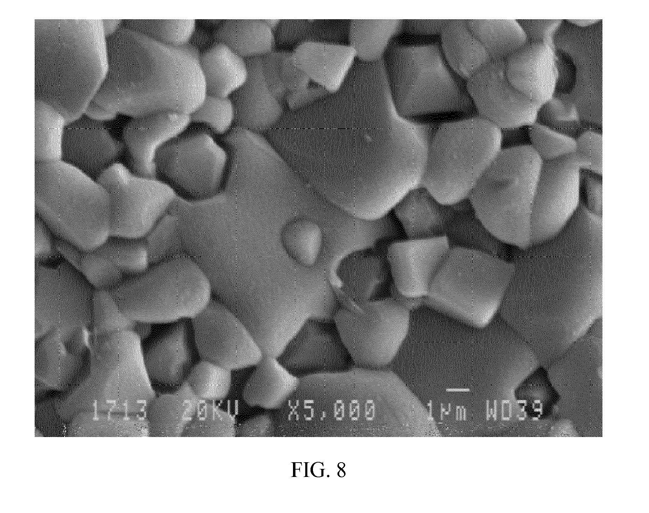

Optionally, a chemical solution may be used to perform surface corrosion and energy activation on the ceramic dielectric body. Specifically, the chemical solution may include two parts: a silver salt solution and a reducing agent. The silver salt solution is 58g/L silver nitrate, 42g/L sodium hydroxide, and adequate ammonia water (until the solution is settled), and the rest is de-ionized water. The reducing agent may be 45g/L glucose, 100mL/L anhydrous alcohol, and 3g/L tartaric acid, and the rest is de-ionized water. FIG. 7 is an electron micrograph of a surface of a dielectric body magnified by 5000 times after corrosion processing; and FIG. 8 is an electron micrograph of a surface of a dielectric body magnified by 5000 times without processing. As shown in FIG. 7 and FIG. 8, in comparison with a ceramic based body that does not undergo chemical corrosion, a ceramic body that undergoes chemical corrosion and surface energy activation has higher surface activity, and shows a stronger three-dimensional effect of microscopic crystal grains and stronger absorptivity. Therefore, catalytic silver ions can be more easily attached to the corroded ceramic body.

On a basis of the foregoing embodiment, S103 of performing plating processing on the surface of the dielectric body after the corrosion processing to form a silver plating layer specifically includes the following processing manners:

In a first processing manner, sputtering silver plating processing is performed on the surface of the dielectric body after the corrosion processing to form a sputtering silver plating layer.

In this embodiment, a common sputtering technology may be used for the sputtering silver plating layer. Preferably, in a case in which the sputtering silver plating processing is performed on the surface of the dielectric body, a control bias voltage is 0.1-10Pa, and a power is 1-40W/cm². For example, the dielectric body is fixed on a sample holder, and rotated at a speed of 20 revolutions per minute; by air extraction, pressure is reduced to lower than 0.5Pa, and argon is input until the pressure reaches 10Pa; a radio frequency power supply is turned on, and the power is adjusted to 35W; a silver target is bombarded for 15 minutes, until a thickness of the deposited silver plating reaches 3-15 micrometers.

In addition, during sputtering silver plating, one or a combination of magnetron sputtering and filtered cathodic vacuum arc silver plating processes may be used. During a filtered cathodic vacuum arc silver plating process, two-stage bias voltages and frequencies need to be controlled. At a first stage, a pulse duration is 15-25S, a frequency is 5-2.5KHz, and a bias voltage is -3000V to -4000V. At a second stage, a duration is 15-2S, a frequency is 1.5-2.5KHz, and a bias voltage range is -2000V to -3500V.

In a second processing manner, chemical catalytic silver plating processing is performed on the surface of the dielectric body after the corrosion processing to form a chemical catalytic silver plating layer.

In this embodiment, on the surface of the dielectric body after the corrosion preprocessing, a film sticker is attached, and areas except a silver plating area are masked; then the dielectric body is placed in a silver plating solution, and chemical self-catalytic silver plating, that is, chemical catalytic silver plating, is performed; after the silver plating is completed, the masking material is removed. In a case in which the silver plating processing is chemical catalytic silver plating processing, a silver plating bath of a non-metal material is adopted. The dielectric body after the chemical corrosion is placed in a silver plating solution, and silver plating is performed. The adopted silver plating solution includes the following components: 0.01-650g/L silver salt, 1-1000mL/L ammonium bifluoride, 0.01-210g/L ammonium carbonate and/or ammonium bicarbonate, and 0.01-210g/L hydrazine hydrate, and a speed for performing the chemical catalytic silver plating processing is 0.1-2um/h. PH of the silver plating solution is about 8-13.

Preferably, a silver plating solution including the following components may be used: 100g/L silver nitrate, 500mL/L ammonium bifluoride, 10g/L ammonium carbonate and/or ammonium bicarbonate, and 0.01-210g/L hydrazine hydrate. The silver salt is 100g/L silver nitrate, that is, a 1L silver plating solution includes 100g silver nitrate, and PH of the silver plating solution is about 11.

In a third possible implementation manner, sputtering silver plating processing is performed on the surface of the dielectric body after the corrosion processing to form a sputtering silver plating layer, and chemical catalytic silver plating processing is performed on a surface of the sputtering silver plating layer to form a chemical catalytic silver plating layer.

In this embodiment, on the surface of the dielectric body after the corrosion preprocessing, a film sticker is attached, and areas except a silver plating area are masked; sputtering silver plating is performed on the surface of the dielectric body to which the film sticker is attached to form a sputtering silver plating layer; then the dielectric body is placed in a silver plating solution, and chemical catalytic silver plating is performed to form a silver plating layer as shown in FIG. 4; after the silver plating of the dielectric body is completed, the masking film sticker is removed, and an open-circuit ceramic part is exposed. Specific implementation manners of the sputtering silver plating processing and the chemical catalytic silver plating are consistent with the foregoing manners.

Optionally, a chemical self-catalytic silver plating technology may be used for the chemical catalytic silver plating layer. The dielectric body after the corrosion processing is directly placed in a chemical silver solution (for example, silver nitrate), and the processing may be performed at a temperature of 40-80 degrees Celsius (preferably, 63 degrees); a 0.1um plating layer is formed slowly under an action of an electromagnetic stirrer; then the plating layer is thickened in a denser silver plating solution, until a required thickness is reached.

In a fourth possible implementation manner, chemical catalytic copper plating processing is performed on the surface of the dielectric body after the corrosion processing to form a chemical catalytic copper plating layer, and chemical catalytic silver plating processing is performed on a surface of the chemical catalytic copper plating layer to form a chemical catalytic silver plating layer.

In this embodiment, a chemical catalytic copper plating technology may be used for the dielectric body after the corrosion processing (preferably, a thickness of the chemical catalytic copper plating layer is 0.5-7 µ m); then catalytic silver plating is implemented on the formed chemical catalytic copper plating layer, where a thickness of the silver layer may be preferably 1-3um; after the silver plating is completed, the masking film sticker is removed, and the dielectric body part is exposed. During chemical catalytic copper plating, a silver plating solution including the following components may be used: 5-15 g/L copper sulfate, 20-60 g/L ethylenediamine tetraacetic acid, 5-15g/L sodium hydroxide, 37% formaldehyde, 2,2'-Bipyridine, and 40-80mg/L potassium ferrocyanide, and a solution is prepared by using de-ionized water. Preferably, the silver plating solution may be: 10g/L copper sulfate, 40g/L ethylenediamine tetraacetic acid, 10g/L sodium hydroxide, 10ml/L 37% formaldehyde, 20mg/L 2,2'-Bipyridine, and 60mg/L potassium ferrocyanide, and a solution is prepared by using de-ionized water.

According to the method for manufacturing the TEM mode dielectric filter provided by this embodiment, a material having a low dielectric constant is used as a dielectric body to enlarge a resonant cavity, increase an energy storage space, and increase a quality factor of the filter; and technologies such as sputtering silver plating, chemical catalytic silver plating, and chemical catalytic copper plating are used on the surface of the dielectric body to form a silver plating layer, and a silver plating technology on the silver plating layer is optimized. Therefore, a thickness of the silver plating layer is increased, electrical conductivity is improved, and an insertion loss of the TEM mode dielectric filter is reduced.

On a basis of the foregoing embodiment, specifically, a material such as an aluminum oxide based ceramic material, a quadrivalent silicate based ceramic material, a quinquevalent vanadate based ceramic material, or a hexavalent tungstate/molybdate based ceramic material may be used as the dielectric body. A most proper range of the dielectric constant of the material selected as the dielectric body is 7 to 21.

In addition, a duration of the chemical catalytic silver plating may be 5-60 minutes; preferably, the duration is 5-30 minutes; and generally, 20 minutes is preferred. A temperature for the chemical catalytic silver plating may be 20-98 degrees Celsius, and preferably, the temperature is 50-90 degrees Celsius. It is concluded in an experiment that the most proper temperature is 63 degrees Celsius.

According to the method for manufacturing the TEM mode dielectric filter provided by this embodiment, a material having a dielectric constant within a range of 7-21 is selected; silver plating processing is performed at a proper temperature; an original silver paste dipping technology is improved; and one or more manners of sputtering silver plating, chemical catalytic silver plating, or chemical catalytic copper plating are used to form a denser silver plating layer on a surface of the dielectric body. Therefore, electrical conductivity is improved greatly, and an insertion loss of the filter is reduced.

Finally, it should be noted that the foregoing embodiments are merely intended for describing the technical solutions of the present invention, but not for limiting the present invention. Although the present invention is described in detail with reference to the foregoing embodiments, persons of ordinary skill in the art should understand that they may still make modifications to the technical solutions described in the foregoing embodiments or make equivalent replacements to some or all technical features thereof, without departing from the scope of the technical solutions of the embodiments of the present invention.

## Claims

1. A transverse electromagnetic,TEM mode dielectric filter, wherein the TEM mode dielectric filter comprises a dielectric body and a silver plating layer, wherein the silver plating layer covers a surface of the dielectric body, and a dielectric constant of the dielectric body is less than or equal to 21.

2. The TEM mode dielectric filter according to claim 1, wherein:
the silver plating layer is a sputtering silver plating layer; or
the silver plating layer is a chemical catalytic silver plating layer; or
the silver plating layer comprises a sputtering silver plating layer and a chemical catalytic silver plating layer that are formed in sequence on the surface of the dielectric body, wherein the sputtering silver plating layer is located between the dielectric body and the chemical catalytic silver plating layer; or
the silver plating layer comprises a chemical catalytic copper plating layer and a chemical catalytic silver plating layer that are formed in sequence on the surface of the dielectric body, wherein the chemical catalytic copper plating layer is located between the dielectric body and the chemical catalytic silver plating layer.

3. The TEM mode dielectric filter according to claim 1 or 2, wherein the dielectric constant of the dielectric body is between 7 and 21.

4. The TEM mode dielectric filter according to any one of claims 1 to 3, wherein the dielectric body comprises an aluminum oxide based ceramic material, a quadrivalent silicate based ceramic material, a quinquevalent vanadate based ceramic material, or a hexavalent tungstate/molybdate based ceramic material.

5. The TEM mode dielectric filter according to any one of claims 1 to 4, wherein a thickness of the silver plating layer is 3-15 micrometers.

6. A method for manufacturing a transverse electromagnetic,TEM mode dielectric filter, wherein the method comprises:
acquiring a dielectric body, wherein a dielectric constant of the dielectric body is less than or equal to 21;
performing corrosion processing on a surface of the dielectric body; and
performing plating processing on the surface of the dielectric body after the corrosion processing to form a silver plating layer.

7. The manufacturing method according to claim 6, wherein the performing plating processing on the surface of the dielectric body after the corrosion processing to form a silver plating layer comprises:
performing sputtering silver plating processing on the surface of the dielectric body after the corrosion processing to form a sputtering silver plating layer; or
performing chemical catalytic silver plating processing on the surface of the dielectric body after the corrosion processing to form a chemical catalytic silver plating layer; or
performing sputtering silver plating processing on the surface of the dielectric body after the corrosion processing to form a sputtering silver plating layer, and performing chemical catalytic silver plating processing on a surface of the sputtering silver plating layer to form a chemical catalytic silver plating layer; or
performing chemical catalytic copper plating processing on the surface of the dielectric body after the corrosion processing to form a chemical catalytic copper plating layer, and performing chemical catalytic silver plating processing on a surface of the chemical catalytic copper plating layer to form a chemical catalytic silver plating layer.

8. The manufacturing method according to claim 6 or 7, wherein in a case in which the plating processing is sputtering silver plating processing, an adopted control bias voltage is 0.1-10Pa, and an adopted power is 1-40W/cm².

9. The manufacturing method according to claim 7 or 8, wherein in a case in which the plating processing is chemical catalytic silver plating processing, an adopted silver plating solution comprises the following components: 0.01-650g/L silver salt, 1-1000mL/L ammonium bifluoride, 0.01-210g/L ammonium carbonate and/or ammonium bicarbonate, and 0.01-210g/L hydrazine hydrate, and a speed for performing the chemical catalytic silver plating processing is 0.1-2um/h.

10. The manufacturing method according to claim 9, wherein the silver salt is silver nitrate.

11. The manufacturing method according to any one of claims 6 to 10, wherein a thickness of the silver plating layer is 3-15 micrometers.

12. The manufacturing method according to any one of claims 6 to 11, wherein the dielectric constant of the dielectric body is greater than or equal to 7 and less than or equal to 21.

13. The manufacturing method according to any one of claims 6 to 12, wherein the dielectric body comprises an aluminum oxide based ceramic material, a quadrivalent silicate based ceramic material, a quinquevalent vanadate based ceramic material, or a hexavalent tungstate/molybdate based ceramic material.
